# EUROPÄISCHE PATENTANMELDUNG

(11) **EP 0 989 261 A2**
(43) Veröffentlichungstag der Anmeldung: **29.03.2000**
(21) Anmeldenummer: 99250327.6
(22) Anmeldetag: 16.09.1999
(51) Int. Cl.: E05B 17/22, E05B 17/14, E05B 13/10, H02B 1/38

(54) **Elektrische Kontaktverbindung**

(30) Priorität: 21.09.1998 DE 29817774 U
(71) Anmelder: IKON AKTIENGESELLSCHAFT Präzisionstechnik, D-14167 Berlin (DE)
(72) Erfinder: Sengupia, Pritimay, 12207 Berlin (DE)

(57) **Zusammenfassung**

Die Erfindung betrifft eine elektrische Kontaktverbindung zwischen beiderseits einer ortsfesten Trennwand (5) angeordneten, um eine gemeinsame Achse drehbaren Teilen (1,7), wobei in der Trennwand (5) entsprechend dem Drehwinkel der Teile Durchgangsöffnungen (3) für die beide Teile verbindenden Befestigungsmittel (4) vorgesehen sind, wobei ferner an dem einen Teil eine elektrisch/elektronische Baugruppe vorgesehen ist, die mit einer am anderen Teil vorgesehenen elektrisch/elektronischen Baugruppe leitend verbunden ist und wobei die leitende Verbindung aus Drähten (2) besteht, die durch axiale Bohrungen in den Befestigungsmitteln (4) oder Ausnehmungen an der Peripherie der Befestigungsmittel (4) von einer Baugruppe zur anderen Baugruppe geführt sind.

## Beschreibung

Die Erfindung betrifft eine elektrische Kontaktverbindung.

Bei einer Vielzahl von betrieblichen und privaten Einrichtungen besteht häufig die Notwendigkeit Schränke, Gehäuse oder dgl. durch ein Sicherheitsschloß vor fremden und unberechtigten Zugang zu schützen.
Besonders auf dem Gebiet der Telekommunikations- und Datentechnik besteht das Problem die Kabel oder Datenleitungen und deren Anschluß-, Verzweigungs -oder Verbindungspunkte zu sichern. Hierzu werden häufig Schaltschränke oder Verzweigergehäuse benutzt, die mittels eines Sicherheitsschlosses verschließbar sind.

Ein derartiges Verteilergehäuse ist aus der DE 19650847 bekannt. Dabei ist das Sicherheitsschloß in einer Griffmuschel untergebracht, die sich auf der Außenseite der Tür des Gehäuses befindet. Dieser Griffmuschel sind im Inneren des Gehäuses entsprechende Teile zugeordnet, die beispielsweise eine elektromechanische Sperre für eine Schlüssellochsicherung, d.h. Schlüssellochabdeckung aufnehmen. Da zum eigentlichen Öffnen der Tür die Griffmuschel verdreht wird, unterliegen elektrische Kontaktverbindungen großen Beanspruchungen, so daß Beschädigungen nicht zu vermeiden sind.

Die Aufgabe der Erfindung ist es daher, eine elektrische Kontaktverbindung für solche Einrichtungen zu schaffen, bei denen zwei gemeinsam verdrehbare Teile sich beiderseits einer Trennwand befinden.

Gelöst wird diese Aufgabe erfindungsgemäß durch eine elektrische Kontaktverbindung zwischen beiderseits einer ortsfesten Trennwand angeordneten, um eine gemeinsame Achse drehbaren Teilen, wobei in der Trennwand entsprechend dem Drehwinkel der Teile Durchgangsöffnungen für die beide Teile verbindenden Befestigungsmittel vorgesehen sind, wobei ferner an dem einen Teil eine elektrisch/elektronische Baugruppe vorgesehen ist, die mit einer am anderen Teil vorgesehenen elektrisch/elektronischen Baugruppe leitend verbunden ist und wobei die leitende Verbindung aus Drähten besteht, die durch axiale Bohrungen in den Befestigungsmitteln oder Ausnehmungen an der Peripherie der Befestigungsmittel von einer Baugruppe zur anderen Baugruppe geführt sind.

Die Befestigungsmittel können hierbei Schrauben sein.

Besonders vorteilhaft ist diese erfindungsgemäße Lösung bei Anwendung auf die vorstehend genannten Verzweigergehäuse. Bei diesen befindet sich in der Baugruppe an dem einen, in diesem Fall der äußeren Griffmuschel ein Lesekopf. Mit dessen Hilfe werden elektronische Codierungen abgefragt, die sich an oder in einem Codeträger befinden. Dieser Lesekopf steht mit einer Auswerteeinheit leitend in Verbindung, die sich im Inneren des Verzweigergehäuses befindet. Über die Auswerteeinheit kann dann beispielsweise die elektromechanische Sperre für die Schlüssellochsicherung beeinflußt werden.

Zum besseren Verständnis soll ein derartiger Aufbau als Beispiel für eine erfindungsgemäße Ausführung an den Zeichnungen erläutert werden.

Dabei zeigt:

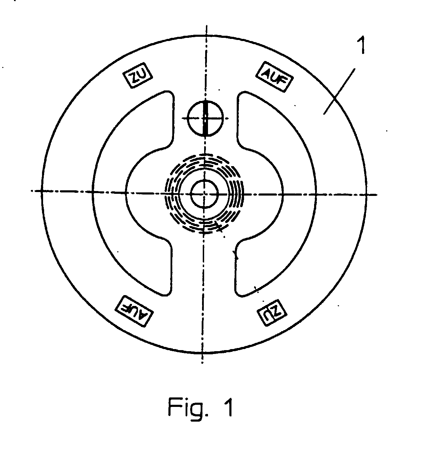

Fig. 1 eine Aufsicht auf eine Griffmuschel,
Fig. 2 eine Ansicht des inneren Teiles bei abgenommener Abdeckung,
Fig. 3 eine vereinfachte Seitenansicht und
Fig. 4 eine Ansicht der Baueinheit an dem inneren Teil.

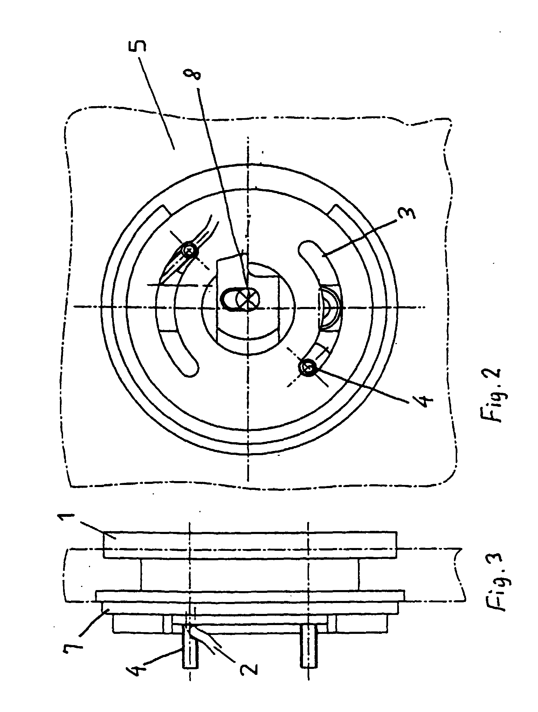

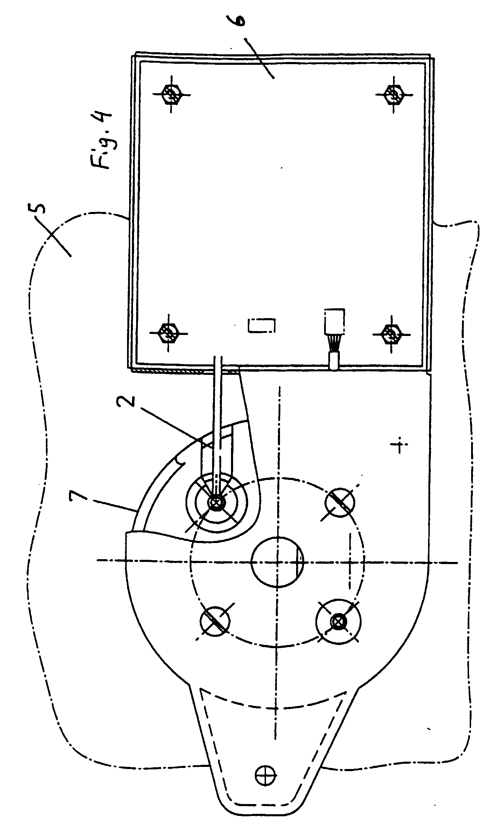

Die Einrichtung zum Verschließen eines Verzweigergehäuses der in der vorstehend genannten Patentschrift beschriebenen Art weist eine Griffmuschel 1 auf, die sich auf der Außenseite der Tür des Verzweigergehäuses befindet. Auf der anderen, also inneren Seite des Türblattes 5 ist das Teil 7 angeordnet. Die Griffmuschel ist mit diesem Teil 7 über Schrauben 4 verbunden. Beide Teile, d.h. die Griffmuschel und das innere Teil sind um eine gemeinsame Achse 8 drehbar. Im Türblatt sind Schlitze 3 vorgesehen, deren Erstreckung dem Drehwinkel der Teile entspricht. Zwischen der nicht dargestellten äußeren elektrisch/elektronischen Baugruppe und der am inneren Teil 7 angeflanschten elektrisch/elektronischen Baugruppe 6 besteht eine elektrische Kontaktverbindung. Hierbei handelt es sich um Drähte 2. Damit diese Drähte bei der Drehbewegung der beiden Teile 1 und 7 relativ zum Türblatt 5 nicht beschädigt werden, sind diese entweder durch axiale Bohrungen in den Schrauben hindurchgeführt ( Fig.3 ) oder verlaufen entlang von Ausnehmungen an der Peripherie der Schrauben.
Wie die Figur 4 erkennen läßt, ist die Baugruppe 6 am inneren Teil über eine angeschraubte Platte mit diesem verbunden. Diese Baugruppe macht somit die Drehbewegung der Teile mit. Eine Montage freundliche Zugänglichkeit ist gesichert.

## Patentansprüche

1. Elektrische Kontaktverbindung zwischen beiderseits einer ortsfesten Trennwand (5) angeordneten, um eine gemeinsame Achse drehbaren Teilen (1,7), wobei in der Trennwand (5) entsprechend dem Drehwinkel der Teile (1,7) Durchgangsöffnungen (3) für die beide Teile verbindenden Befestigungsmittel (4) vorgesehen sind, wobei ferner an dem einen Teil eine elektrisch/elektronische Baugruppe vorgesehen ist, die mit einer am anderen Teil vorgesehenen elektrisch/elektronischen Baugruppe leitend verbunden ist und wobei die leitende Verbindung aus Drähten (2) besteht, die durch axiale Bohrungen in den Befestigungsmitteln (4) oder Ausnehmungen an der Peripherie der Befestigungsmittel (4) von einer Baugruppe zur anderen Baugruppe geführt sind.

2. Elektrische Kontaktverbindung nach Anspruch 1,
dadurch gekennzeichnet,
daß die Befestigungsmittel (4) Schrauben sind.

3. Elektrische Kontaktverbindung nach einem der vorstehenden Ansprüche,
dadurch gekennzeichnet,
daß die eine elektrisch/elektronische Baugruppe einen elektronischen Lesekopf zur Aufnahme von elektronischen Codierungen enthält und daß die andere Baugruppe eine Auswerteeinheit für diese Codierungen enthält.
